Europäisches Patentamt

European Patent Office

Office européen des brevets

(11) Veröffentlichungsnummer: **0 353 433**
**A1**

## (12) EUROPÄISCHE PATENTANMELDUNG

(21) Anmeldenummer: 89110774.0

(22) Anmeldetag: 14.06.89

(51) Int. Cl.⁴: **H01L 39/24** , **H01F 5/08**

(30) Priorität: 14.07.88 CH 2707/88

(43) Veröffentlichungstag der Anmeldung:
07.02.90 Patentblatt 90/06

(84) Benannte Vertragsstaaten:
CH DE FR GB IT LI

(71) Anmelder: **ASEA BROWN BOVERI AG**
**Haselstrasse**
**CH-5401 Baden(CH)**

(72) Erfinder: **Bruzzone, Pierluigi, Dr.**
**Eugen Huberstrasse 61**
**CH-8048 Zürich(CH)**
Erfinder: **Nylund, Knut**
**Gartenstrasse 9**
**CH-8102 Oberengstringen(CH)**

(54) **Supraleitende Magnetwicklung und Verfahren zu deren Herstellung.**

(57) Bei supraleitenden Wicklungen, die nach der
"wind and react"-Technik hergestellt werden, besteht die eigentliche Isolationsschicht aus einer plasmagespritzen Oxydschicht (14), die unter Zwischenschaltung einer gleichfalls plasmagespritzen Haftschicht (13) auf das Leitervorprodukt (16) aufgebracht ist. Eine dünne Umbändelung aus Glasgewebe (15) erleichtert das nachträgliche Imprägnieren
mit Epoxydharz.

# FIG.1

EP 0 353 433 A1

## Supraleitende Magnetwicklung und Verfahren zu deren Herstellung

### Technisches Gebiet

Die Erfindung bezieht sich auf eine supraleitende Magnetwicklung, die aus mit einer Leiterisolation versehenen Leitervorprodukten aufgebaut ist, und bei der die supraleitenden Eigenschaften durch eine Reaktionsglühung der fertigen Wicklung erzeugt sind.

Die Erfindung bezieht sich ferner auf ein Verfahren zur Herstellung einer derartigen Wicklung.

Die Erfindung geht dabei aus von einem Stand der Technik, wie er sich beispielsweise aus der EP-PS 0 048 880 ergibt.

### Technologischer Hintergrund und Stand der Technik

Supraleitende intermetallische Verbindungen mit A15-Kristallstruktur, wie beispielsweise die zweikomponentigen Verbindungn $Nb_3Sn$ und $V_3Ga$ oder die ternäre Verbindung $Nb_3Al_{0.8}Ge_{0.2}$, haben gute Supraleitungseigenschaften und zeichnen sich durch hohe kritische Werte aus, d.h. durch eine hohe Sprungtemperatur, eine hohe kritische Stromdichte und ein hohes kritisches Magnetfeld.

Sie eignen sich daher besonders als Leitermaterialien für Supraleitungsmagnetspulen zum Erzeugen starker Magnetfelder.

Die supraleitenden, intermetallischen Verbindungen sind jedoch im allgemeinen sehr spröde, so dass ihre Herstellung in einer für Magnetspulen geeigneten Form mit Schwierigkeiten verbunden ist. Man geht heute im allgemeinen derart vor, dass zunächst ein Stab oder Draht aus dem höherschmelzenden Element der Verbindung mit einer Hülle aus einer Legierung versehen wird, die aus einem Trägermetall und dem niedrigschmelzenden Element der Verbindung bzw. gegebenenfalls mehreren solchen Elementen besteht. Beispielsweise wird ein Niob-Draht mit einer Hülle aus Cu-Zinn-Bronze umgeben. Eine Vielzahl dieser umhüllten Drähte wird dann zu einem Bündel zusammengefasst. Man kann aber beispielsweise auch mehrere Drähte in einen mit Bohrungen versehenen Block aus der Bronze einlagern. Der so gewonnene Aufbau wird dann einer querschnittsverringernden Bearbeitung unterzogen. Man erhält so einen Draht oder ein Band aus einer Legierungsmatrix, in die eine Vielzahl von fadenförmigen Kernen aus dem höherschmelzenden Element der Verbindung eingelagert ist, also beispielsweise einen Kupfer-Zinn-Draht mit einer Vielzahl von eingelagerten Niob-Filamenten. Zur Erzeugung der intermetallischen supraleitenden Verbindung wird dann ein solches Leitervorprodukt einer Glühbehandlung unterzogen, bei der das in der Matrix enthaltenen Element der Verbindung in die Kerne aus dem höherschmelzenden Element eindiffundiert und mit diesem unter Bildung der intermetallischen Verbindung reagiert (vgl. z.B. DE-A-20 44 660).

Supraleitende Magnetspulen aus solchen Supraleitern werden bisher im allgemeinen nach zwei verschiedenen Verfahren hergestellt (vgl. z.B. DE-A-28 37 199 und 38 40 526).

Bei dem ersten Verfahren, das auch als "react first-wind then-Verfahren" bezeichnet wird, wickelt man das Leitervorprodukt auf einen provisorischen Wickelkörper auf und glüht es dann zur Bildung der gewünschten supraleitenden Verbindung. Im Anschluss an die Glühbehandlung wird der so hergestellte Supraleiter wieder von dem provisorischen Wickelkörper abgewickelt und kann dann beispielsweise zu einer Magnetspule gewickelt werden. Wegen der hohen Sprödigkeit der supraleitenden intermetallischen Verbindungen besteht dabei jedoch die Gefahr, dass durch unbeabsichtigtes Unterschreiten des für den fertig reagierten Leiter zulässigen Biegerradius in den intermetallischen supraleitenden Verbindungen Risse auftreten und die Supraleitereigenschaften dementsprechend beeinträchtigt werden.

Um diese Gefahr zu umgehen, wendet man ein anderes Verfahren an, das auch als "wind and react-Technik" bezeichnet wird. Dabei bewickelt man den Spulenkörper des mit der Wicklung zu versehenden Magneten mit dem noch nicht reagierten Leitervorprodukt und setzt dann den gesamten so bewickelten Magneten der Diffusionsglühung aus. Da dabei die intermetallische Verbindung erst in situ in der Spule oder Wicklung erzeugt wird, nennt man in diesem Fall die Diffusionglühung auch "in situ-Glühung". Bei dieser Verfahrensweise werden alle Schwierigkeiten der Verarbeitung eines spröden Leitermaterials vermieden. Jedoch müssen die bei der Diffusionsglühung in der Spule vorhandenen Materialien mehrere Stunden lang die erforderlichen hohen Temperaturen aushalten, die beispielsweise im Falle von $Nb_3Sn$ bei etwa 700°C liegen.

Man wickelt daher bisher das mit einer Isolation aus Glas-, Keramik- oder Quarzfäden umwickelte und umsponnene Leitervorprodukt auf einen entsprechend hochtemperaturbeständigen Spulenkörper auf und fixiert die Spulenwindung endgültig erst nach der Diffusionsglühung, indem man die fertige Wicklung mit geeigneten aushärtbaren oder bei Abkühlung erstarrenden organischen Materialien, beispielsweise Epoxidharzen oder Paraffin, vorzugsweise durch Vakuumtränken imprägniert (vgl. DE-A 25 46 198) und 28 37 199).

Auch diese Verfahrensweise ist jedoch nicht frei von Problemen. Es besteht einmal die Schwierigkeit, dass sich bei der Diffusionsglühung Kohlenstof zwischen den Spulenwindungen abscheidet und dadurch die Isolation der Spule verschlechtert wird. Die in der Spulenwicklung üblicherweise verwendeten Isolationsmaterialien aus Glas-, Keramik- oder Quarzfäden sind nämlich zur Erleichterung ihrer Handhabung in der Regel mit organischen Schlichten oder Bindemitteln versehen, die sich bei den hohen Temperaturen zersetzen. Man wendet daher spezielle Verfahren an, um die Schlichten oder Bindemittel vor der Reaktionsglühung aus der Spule zu entfernen (DE-A-28 37 199). Derartige Verfahren erfordern aber einen gewissen Aufwand. Da die erwähnten Isolationsmaterialien mit steigender Temperatur an Festigkeit verlieren, besteht ferner die Gefahr, dass die bei der Glühbehandlung nicht weiter fixierten Windungen ihre Lage und Form ändern. Auch dies kann eine Verschlechterung der Isolation zwischen den Windungen zur Folge haben und ausserdem zu nicht vorhersehbaren Änderungen der Feldverteilung in der Wicklung führen.

Um diese Schwierigkeiten zu vermeiden, wird in der EP-PS 0 048 880 ein Verfahren zum Fixieren der Windungen vorgeschlagen, bei welchem beim Wickeln der Leitervorprodukte ein Kitt aus isolierendem anorganischem Material, der im verfestigten Zustand bei den zur Herbeiführung des supraleitenden Zustandes erforderlichen tiefen Temperaturen beständig ist, zusammen mit Glasfasermatten in die Wicklung eingebracht und nach Fertigstellung der Wicklung vor Durchführung der Reaktionsglühung verfestigt wird. Als Kitt wird ein Gemisch aus Wasserglas und Talcum verwendet.

Bei diesem Verfahren sind eine Reihe von zeitaufwendigen Trocknungsvorgängen bei unterschiedlichen Temperaturen notwendig.

Kurze Darstellung der Erfindung

Der Erfindung liegt die Aufgabe zugrunde, eine supraleitende Magnetwicklung zu schaffen, die extrem temperaturbeständig ist, eine hohe Isolationsqualität aufweist und einfach und wirtschaftlich herzustellen ist.

Diese Aufgabe wird erfindungsgemäss dadurch gelöst, dass das Leitervorprodukt mit einer plasmagespritzen Isolationsschicht vom Oxyd-Typ versehen ist.

Beim zugehörigen Herstellungsverfahren wird - ausgehend von einem bandförmigen Vorprodukt - nach vorgängiger Reinigung und Aufrauhen der Leiteroberfläche der Leiter mittels Plasma-Spritzverfahren allseitig mit einer Oxydschicht versehen, der Leiter zu einer Spule gewickelt und diese Spule einer Reaktionsglühbehandlung unterzogen.

Das Plasma-Spritz-Verfahren gewährleistet eine sehr gute mechanische Verankerung der Keramikteilchen an die Leiteroberfläche. Die microrissige Struktur der Schicht erlaubt grosse Temperaturdifferenzen zu überstehen, trotz dem unterschiedlichen Ausdehnungskoeffizient des metallischen Leiters und des Keramikmaterials. Enge Biegegradien sind ebenfalls für den beschichteten Leiter erlaubt. Die Haftung wird noch verbessert mittels einer Zwischenschicht aus Ni-Legierung, die ebenfalls auf den Leiter gespritzt wird.

Einen optimalen Zusammenhalt des Spulenverbandes erreicht man, wenn der mit der Oxydschicht versehene Leiter vor dem Wickeln mit einer Bandage aus anorganischem Material, vorzugsweise aus entschlichtetem Glas- oder Keramikgewebe, umbandelt wird und die Spule nach der Glühbehandlung mit Tränkharz imprägniert wird. Weil diese Umbandelung nicht mehr Isolationszwecken sondern nur noch dem mechanischen Zusammenhalt und als Tränkharzträger dient, kann die Dicke des anorganischen Materials sehr klein sein.

Die Vorteile des oben beschriebenen Isolationsverfahrens gegenüber der vorhandenen Technik erweisen sich vor allem bei den grossen, mit Stahl umhüllten supraleitenden Kabeln (Fusionsmagnete) und können im folgenden zusammengefasst werden:

- Die Trennung zwischen den Windungen wird durch eine Oxydschicht mit höherer Druckfestigkeit besser gewährleistet (dünnere Leiterisolation).

- Die Haftung des Epoxydharzes an der Oxydschicht ist besser als an der Leiteroberfläche, wegen der porösen Schichtstruktur.

- Der Anteil organischer Komponenten, und daher die Strahlungsempfindlichkeit des Isolationssystemes, wird stark reduziert.

- Die elektrische Isolierung wird auch bei extremen mechanischen Beanspruchungen gewährleistet. Falls Risse in der Glas-Epoxyd-Schicht erscheinen (z.B. wegen sehr hoher Strahlungsdosis), breitet sich dieser Defekt nicht bis zur Leiteroberfläche aus und die Wicklung bleibt funktionsfähig.

- Eventuelle verkohlte Rückstände aus dem Glasgewebe gefährden nicht die elektrische Isolierung der Wicklung.

Kurze Beschreibung der Zeichnung

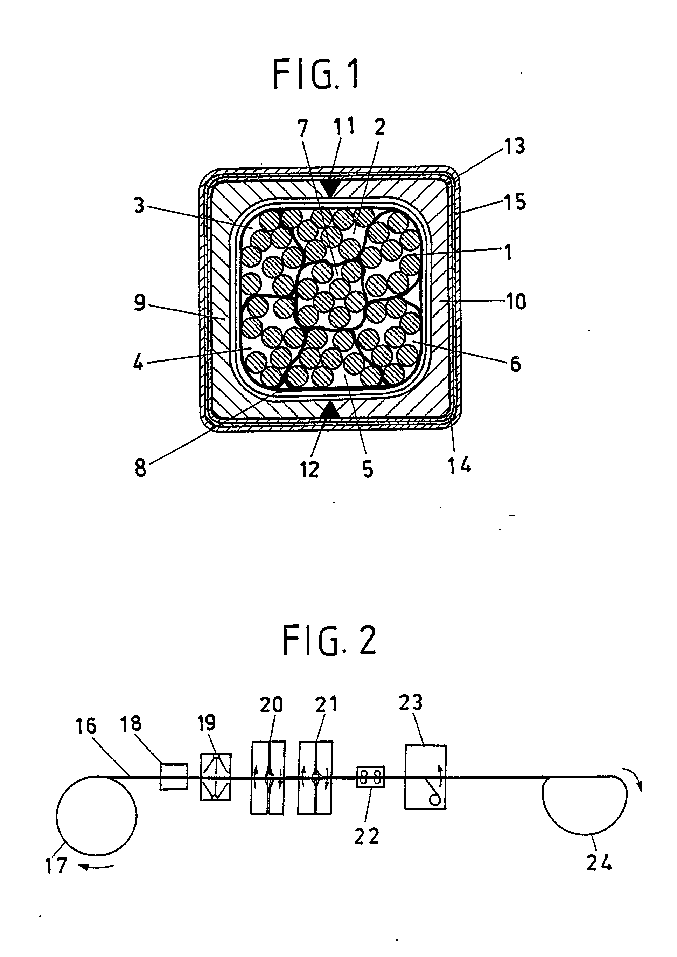

In der Zeichnung ist in Fig. 1 ein Ausführungsbeispiel des erfindungsgemässen Leiters schematisch dargestellt;

Fig.2 zeigt in schematischer Form das Verfahren zur Herstellung einer Spule mit Leitern gemäss Fig 1.

### Detaillierte Beschreibung der Erfindung

In Fig. 1 ist ein Querschnitt durch ein supraleitendes Kabel dargestellt. Das Kabel enthält mehrere äussere Stränge 1 bis 6, die um einen mittleren Strang 7 verseilt oder mit diesem verflochten sind. Jeder Strang besteht aus mehreren Drahtbündeln, die an den Berührungspunkten oder -linien miteinander und mit einer den Strang einschliessenden Hülle 8 verlötet sind. Die Stränge sind in eine Kabelhülse eingelegt, die aus zwei U-förmigen Schalen 9,10 zusammengeschweisst ist. Die Bezugsziffern 11,12 bezeichnen die Schweissnähte.

Die Kabelhülse ist allseitig mit einer Haftschicht 13 aus einer Nickellegierung umgeben, die wiederum von einer plasmagespritzten Oxydschicht 14 bedeckt ist. Diese wiederum ist von einer Schicht 15 aus Glasgewebe umgeben.

In Fig. 1 sind die Schichten 13 bis 15 übertrieben dick eingezeichnet.

Diese Schichten sind in der Praxis sehr dünn. So beträgt die Dicke der Ni-Legierungsschicht 13 etwa 100 μm, die der Oxydschicht 14 etwa 150 μm (dickere Schichten bis zu 0,5 mm sind auch möglich) und die der Glasgewebeschicht 15 etwa 300 μm.

Das Verfahren zur Herstellung eines Leiters, ausgehend vom Vorprodukt in Form eines bandförmigen Leiters 16 gemäss Fig. 1 ist in Fig. 2 skizziert.

Von einer Vorratsrolle 17 gelangt der Leiter 16 durch eine Reinigungsstation 18 und wird anschliessend in der Einheit 19 sandgestrahlt, um die Leiteroberfläche leicht aufzurauhen. In einer ersten Plasmaspritzstation 20 wird der Leiter mit einer Haftschicht 13, vorzugsweise aus einer Nickel-Aluminium-Legierung (Ni5Al) beschichtet. In einer zweiten Plasmaspritzstation 21 wird auf diese Haftschicht 13 die Oxydschicht 14 aufge bracht, wobei im wesentlichen folgende Oxydtypen in Frage kommen:

$Al_2O_3$ + 30% $SiO_2$
$Al_2O_3$ + 30% MgO
$Al_2O_3$ + 20% $Z_rO_2$
$ZrO_2$ + 13% $Y_2O_3$

Jede Station besteht aus zwei oder mehreren Plasmabrennern, die um die Leiter pendeln. Je nach Durchlaufgeschwindigkeit wird das Plasmaspritzen gepulst oder kontinuierlich betätigt.

Plasmaspritzstationen der hier in Frage kommenden Art sind bekannt und beispielsweise in dem Prospekt "Functionally Effective Coatings Using Plasma Spraying" der Firma Plasma-Technik AG, CH-5610 Wohlen, Nr. 86009E, S. 2, Fig. 3, beschrieben. Die bekannten Plasma-Beschichtungsanlagen sind an sich für stationäre Werkstücke bestimmt; für den hier vorgesehenen Zweck können sie jedoch in einfacher Weise modifiziert werden, z B. dadurch, dass der Leiter 16 durch eine Kabine gemäss Fig 5 des genannten Prospekts geführt wird.

An die beiden Stationen 20,21 schliesst sich eine Vorspanneinrichtung 22 mit zwei trennbaren Rollenpaaren an. Danach erfolgt das Umbändeln des Leiters 16 mit einem entschlichtetem Glasgewebeband 14 in einer an sich bekannten Umbändelstation 23. Die Umbändelung erfolgt dabei mit 50% überlappungsgrad oder ohne Überlappung. In der Wickelstation 24 wird die Spule gewickelt und anschliessend bei Hochtemperatur reaktionsgeglüht. Nach deren Fertigstellung wird sie in bekannter Weise mit einem Tränkharz auf Epoxyd-Basis imprägniert.

Das dünne Glasgewebeband 15 erleichtert dabei die Imprägnierung insofern als es eine Rückhaltefunktion für das Tränkharz ausübt. Eingehende Untersuchungen haben gezeigt, dass insbesondere die mit $ZrO_2$-Mischungen beschichteten Prüflinge die gleichen mechanischen Eigenschaften, wie die üblichen Glas-Epoxyd-Komposite aufweisen: Die Kohäsion und die Haftung der plasmagespritzten Oxydschichten sind nach der Glühung und der Abkühlung zu Flüssig-Helium-Temperatur besser, als diejenigen der Glas-Epoxyd-Komposite. Das bessere Verhalten der $ZrO_2$-Mischungen ist auf den höheren Ausdehnungskoeffizienten dieses Oxydes gegenüber anderer Keramik zurückzuführen.

Das Anwendungsgebiet für die vorliegende Erfindung ist die Magnet-Technologie für supraleitende Spulen für Fusionsanlagen, wo Hochspannungsisolation und hohe Strahlungsbeständigkeit zusammen mit einer ausserordentlichen Zuverlässigkeit verlangt werden.

Dieses Verfahren ist aber darüber hinaus für jede grosse supraleitende Spule geeignet, die nach der WR-Technik hergestellt wird.

### Ansprüche

1. Supraleitende Magnetwicklung, die aus mit einer Isolation (14) versehenen Leitervorprodukten (16) aufgebaut ist, und bei der die supraleitenden Eigenschaften durch eine Reaktionsglühung der fertigen Wicklung erzeugt sind, dadurch gekennzeichnet, dass das Leitervorprodukt mit einer plasmagespritzen Isolationsschicht (14) vom Oxyd-Typ versehen ist.

2. Magnetwicklung nach Anspruch 1, dadurch gekennzeichnet, dass die plasmagespritze Isolationsschicht (14) aus Aluminium-Oxyd und einem weiteren Metalloxyd aus der Gruppe Silizium, Magnesium, Zirkon oder Yttrium oder aus Zirkonoxyd und Yttriumoxyd besteht.

3. Magnetwicklung nach Anspruch 1 oder 2, dadurch gekennzeichnet, dass zwischen dem Leiter (16) und der plasmagespritzen Isolationsschicht (14) eine plasmagespritze Haftschicht (13), vorzugsweise auf Nickel-Basis, vorgesehen ist.

4. Magnetwicklung nach einem der Ansprüche 1 bis 3, dadurch gekennzeichnet, dass die plasmagespritze Isolationsschicht (14) von einem porösen anorganischen Isolationsmaterial (15), vorzugsweise entschlichtetes Glasgewebe oder Keramikgewebe, bedeckt ist.

5. Verfahren zur Herstellung der einen supraleitenden Magnetwicklung, die aus mit einer Isolation (14) versehenen Leitervorprodukten (16) aufgebaut wird, und bei der die supraleitenden Eigenschaften durch eine Reaktionsglühung der fertig gewickelten, isolierten Wicklung erzeugt werden, dadurch gekennzeichnet, dass - ausgehend von einem bandförmigen Vorprodukt - nach vorgängiger Reinigung und Aufrauhung der Leiteroberfläche der Leiter mittels Plasmaspritzverfahren mit einer Oxydschicht versehen wird, der Leiter zu einer Spule gewickelt und diese Spule einer Reaktionsglühbehandlung unterzogen wird.

6. Verfahren nach Anspruch 5, dadurch gekennzeichnet, dass vor der Oxydbeschichtung eine Haftschicht (13), vorzugsweise eine Nickellegierung, durch Plasmaspritzen aufgebracht wird.

7. Verfahren nach Anspruch 5 oder 6, dadurch gekennzeichnet, dass vor dem Wickeln der Spule auf den isolierten Leiter eine für ein Tränkharz durchlässige anorganische Schicht (15), vorzugsweise ein Glasgewebe, aufgebracht wird.

8. Verfahren nach Anspruch 7, dadurch gekennzeichnet, dass die Spule nach dem Reaktionsglühen mit Tränkharz, vorzugsweise auf Epoxyd-Basis, imprägniert wird.

# FIG.1

# FIG. 2

88/071

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-1 514 246 (N.V. PHILIPS' GLOEILAMPENFABRIEKEN) * Seite 3, Zeilen 11-25; Seite 7, Anspruch 1 * --- | 1,3,5 | H 01 L 39/24 H 01 F 5/08 |
| A | US-A-4 391 657 (FELDMANN et al.) * Spalte 2, Zeilen 19-66 * --- | 1,2 | |
| D,A | EP-A-0 048 880 (VACUUMSCHMELZE GmbH) * Zusammenfassung * --- | 1,5 | |
| A | EP-A-0 008 431 (SIEMENS AG) * Zusammenfassung * & DE-A-2 837 199 (Kat. D,A) --- | 1 | |
| A | GB-A-1 138 312 (ALLMÄNNA SVENSKA ELEKTRISKA AB) * Seite 2, Zeilen 74-80 * --- | 1-3 | |
| A | DE-B-1 284 502 (N.V. PHILIPS' GLOEILAMPENFABRIEKEN) * Insgesamt * ----- | 1,3,5,8 | RECHERCHIERTE SACHGEBIETE (Int. Cl.5) H 01 L H 01 F |

Der vorliegende Recherchenbericht wurde für alle Patentansprüche erstellt

| Recherchenort | Abschlußdatum der Recherche | Prüfer |
|---|---|---|
| DEN HAAG | 17-10-1989 | BAILLET B.J.R. |